# EUROPEAN PATENT APPLICATION

(11) **EP 3 675 166 A1**
(43) Date of publication of application: **01.07.2020**
(21) Application number: 18306847.7
(22) Date of filing: 26.12.2018
(51) Int. Cl.: H01L 27/01, H01L 29/94, H01L 49/02, H01L 27/06

(54) **RC COMPONENTS, AND METHODS OF FABRICATION THEREOF**

(71) Applicant: Murata Manufacturing Co., Ltd., Nagaokakyo-shi, Kyoto 617-8555 (JP)
(72) Inventor: JACQUELINE, Sébastien, 14000 Caen (FR); AUBRY, Yves, 14000 Caen (FR); LENOIR, Lionel, 14000 Caen (FR)
(74) Representative: Cabinet Beau de Loménie

(57) **Abstract**

RC components (10) are described which comprise a substrate (2) provided with a 3D capacitor (4-6) and with a resistor (15) connected in series with the 3D capacitor. The connection terminals (18,12) of the RC component are provided on respective first (2a) and second sides (2b) of the substrate (2), the first and second sides (2a,2b) facing each other in the thickness direction of the substrate. The resistor (15) is a conductor extending along the surface of the substrate on the first side (2a) of the substrate. The components may be monolithic devices. The components may be RC snubbers. Corresponding fabrication methods are described.

## Description

### Field of the Invention

The present invention relates to electronic components which incorporate the constituents of an RC network, and to methods of fabrication of such RC components.

### Technical Background

Many electrical circuits require connection to an RC network. For example, RC networks are often connected to power electronics devices and used as "snubbers" to prevent or attenuate voltage transients (spikes) caused by rapid changes in current, to damp oscillations or overshoot due to inductive load switching and so on. Typically, the voltage transients are generated by reactances in a power circuit. The reactances may be parasitic.

A widely-used damping snubber network architecture consists of a resistor and a capacitor connected in series with one another. Typically, the damping RC snubber network is connected in parallel with a reactance in a power electronics device.

It is desirable for the values of the resistance and capacitance in an RC component to be set with precision. For example, when an RC network constitutes an RC snubber the impedance of the snubber should match the characteristic impedance of the circuit being snubbed in order for optimal attenuation performance to be achieved and so the attenuation performance may be degraded if the resistance and capacitance values of the RC snubber do not match their target values.

Snubber networks absorb energy during operation and so they heat up. Accordingly, they often need to withstand relatively large temperature ranges, for example from room temperature up to around 200°C. There is a need for an RC component in which the values of the resistance and capacitance remain stable despite changes in temperature.

It is desirable for a snubber network's resistor and capacitor to be able to withstand significant voltage levels (several tens or hundreds of volts) and current levels (several amps or tens of amps). This improves the response of the snubber network to signals which have fast rise times.

When an RC network constitutes an RC snubber it is desirable for the interconnection between the network and the circuit being snubbed to be a low inductivity connection, or else the resistor of the RC network may become decoupled by parasitic inductance of the interconnection line and the attenuation performance of the snubber may be degraded.

To reduce costs, as a general matter it is desirable to reduce the number of components and the surface area of electronics boards.

To enable standardisation, it is desirable to develop so-called IPDs (Integrated Passive Devices) which can be associated with various power circuits.

RC networks can be implemented in various ways. One conventional approach for implementing an RC network consists in soldering a discrete resistor and a discrete capacitor onto a printed circuit board. A disadvantage of this first approach is that the discrete components occupy a large surface area on the mounting board. A second approach consists in integrating an RC network with an active circuit (e.g. a power transistor). However, this second approach has the disadvantage that the fabrication of the circuit becomes complicated and, also, it is necessary to develop a bespoke arrangement for each different active circuit that needs to be associated with an RC network.

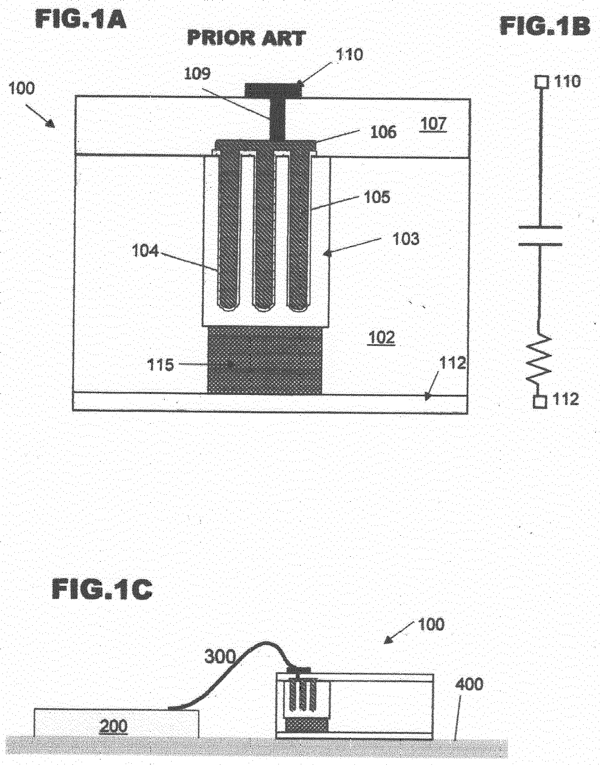

In US 7,738,226 a proposal has been made to produce a monolithic RC snubber component, that is, a single device incorporating an interconnected resistance and capacitance (and, in some examples, other components). Various configurations of monolithic snubber are described in US 7,738,226, including a monolithic RC component in which one terminal of the RC network is provided on a bottom surface of the component and the other terminal of the RC network is provided on the top surface of the component. Appended Fig.1A is a diagram representing a cross-sectional view through a monolithic RC component 100 having this configuration, Fig.1B shows the equivalent circuit, and Fig.1C illustrates how the RC component 100 may be connected in parallel to a device 200 that requires snubbing.

As can be seen from Fig.1A, the RC component 100 comprises a semiconductor substrate 102 which has a first doped region 103 and a second doped region 115. The first doped region 103 in the substrate 102 defines the bottom electrode of a three-dimensional (3D) capacitor. The 3D capacitor structure is formed over texture at the top surface of the substrate 102. In Fig.1A the texture takes the form of holes which extend from the top surface of the substrate 102 into the first doped region 103, but the textured surface may take other forms (e.g. trenches, columns, ...). A continuous dielectric layer 104 lines the walls of the holes. The dielectric layer 104 constitutes the dielectric of the 3D capacitor. The top electrode of the 3D capacitor is formed by a conductive layer 105 which fills the holes and has a linear or planar portion 106 at the top surface of the substrate. The surface portion 106 constitutes the top electrode of the 3D capacitor. Thus, here the 3D capacitor has a MIS structure (metal-insulator-semiconductor).

A protective layer 107 covers the top surface of the substrate 102; this protective layer is an electrical insulator. A top terminal 110 of the RC component 100 is formed on the top surface of the protective layer 107 and a via hole conductor 109 connects the top terminal 110 of the RC component 100 to the top electrode 106 of the 3D capacitor. A conductive layer 112 is provided on the bottom surface of the substrate 102. The second doped region 115 is located between the conductive layer 112 and the bottom electrode 103 of the 3D capacitor, and provides electrical connection between the 3D capacitor and the conductive layer 112. The second doped region 115 constitutes the resistor of the RC network and the resistance value can be varied by varying the doping level. The conductive layer 112 constitutes a bottom terminal of the RC component 100. This bottom terminal may be soldered or sintered to a conductive mounting surface.

In the RC component 100 represented in Figs.1A-1C, the capacitor and resistor structures extend through the substrate in the direction of the substrate's thickness, and are arranged successively between the top and bottom surfaces of the component. The terminals 110, 112 provided on the opposite sides of the RC component 100 (opposite sides in the thickness direction of the substrate) make it possible to use a space-saving arrangement to connect the RC component 100 in parallel to other devices, as illustrated in Fig.1C.

Fig.1C illustrates a case in which the RC component 100 and a device to be snubbed 200 are both mounted on a direct bonded copper (DBC) substrate 400. Because the top surface of the DBC substrate is conductive, it interconnects the bottom terminal 112 of the RC component 100 with a bottom terminal (not shown) of the device 200. A bonding wire 300 electrically connects the top terminal 110 of the RC component 100 to a terminal (not shown) provided on the top surface of the device 200. With an arrangement of this kind, the RC component can be mounted in the direct vicinity of the associated device 200. In the case where the RC component 100 is a snubber, this facilitates a low inductance interconnection.

Although the monolithic RC component 100 illustrated in Fig.1A facilitates a compact and low-inductivity connection arrangement as illustrated in Fig.1C, the component 100 has the disadvantage that it is difficult to adequately control the resistance value of the resistor in the RC network. The resistance value of the resistor is set by the doping of the doped region 115 created in the bulk of the substrate 102. Usual doping processes produce undesirable variation in the resistance value that is achieved in the finished products. Moreover, there is a high rate of drift in the resistance value of a silicon substrate region that is doped to have high resistivity.

The paper "Monolithic RC-Snubber for Power Electronic Applications" by vom Dorp, et al (IEEE PEDS 2011, Singapore 5-8 Dec 2011) involves authors overlapping with those of US 7,738,226 and describes a monolithic snubber comparable with that illustrated in appended Figs.1A-1C except that the resistor is constituted, not by a second doped region in the substrate, but instead by the bulk substrate material that is located between the first doped region (which constitutes the bottom electrode of the 3D capacitor) and the bottom conductive layer. Results reported in the paper mention a significant temperature coefficient of resistance (variation in the resistance value as the temperature changes), notably 3269 ppm/K.

The present invention has been made in the light of the problems discussed above.

### Summary of the Invention

The present invention provides an RC component comprising:
a substrate provided with a 3D capacitor and with a resistor connected in series with the 3D capacitor;
wherein the connection terminals of the RC component are provided on respective first and second sides of the substrate, the first and second sides facing each other across the thickness of the substrate; and
wherein the resistor is a conductor extending along the surface of the substrate on the first side of the substrate.

Embodiments of RC component according to the invention can be connected to other devices in a space-saving and low inductance arrangement and have a well-controlled resistance value of the resistor included in the RC network. The nominal resistance value may be set with precision (<10% variation from the target value) and there is little variation in the resistance value as the temperature changes (of the order of a few 100s of ppm/K). It will be appreciated that the temperature drift is at least an order of magnitude better than that reported, in the vom Dorp paper, for the device resembling that of Figs.1A-1C.

Embodiments of RC component according to the invention can withstand significant voltage levels and only a small surface area is required for mounting the component on an electronics board. When the RC component is used as a snubber network, there is a good response of the snubber network to signals which have fast rise times. Embodiments of RC component according to the invention may constitute IPDs that can be associated with various power circuits.

In certain embodiments of the invention, the resistor is a conductor extending along the surface of the substrate on the first side of the substrate, the conductor extending from a first electrode of the 3D capacitor to the connection terminal on the first side of the substrate. In this case, the nominal value of the resistance can be adjusted in a simple manner by patterning the conductor to set its dimensions.

In certain embodiments of the invention, the resistor is a polysilicon conductor. In certain embodiments of the invention, a common polysilicon layer constitutes the polysilicon resistor and a first electrode of the 3D capacitor. In this case the manufacturing process is simplified because a single deposition process can be used to form the capacitor electrode and the polysilicon resistor.

In certain embodiments of the invention, the connection terminal on the first side of the substrate is made of aluminium or of an alloy containing at least 98% aluminium. In this case the precision of setting of the nominal value of the resistance may be increased.

The present invention further provides a method of fabricating an RC component, comprising:
forming a 3D capacitor in a substrate;
forming a resistor along the surface of the substrate on a first side of the substrate, the resistor being connected in series with the 3D capacitor; and
forming connection terminals of the RC component on the first side and on a second side of the substrate, respectively, the first and second sides facing each other across the thickness of the substrate.

The method may include forming the resistor by depositing a polysilicon layer and adjusting the dimensions of the polysilicon layer to set the resistance value of the resistor.

The method may include a high temperature annealing of the polysilicon material. High temperature annealing of the polysilicon material produces a significant improvement in the consistency of the resistance value that is observed across different products in a manufactured batch.

The 3D capacitor may be made using different technologies. In some embodiments of the invention the forming of the 3D capacitor comprises texturing the surface of a doped semiconductor substrate (e.g. by selective etching), forming a continuous dielectric layer conformally over the texture in the doped semiconductor substrate, and forming, on the dielectric layer, a polysilicon layer constituting an electrode of the 3D capacitor and constituting said resistor. In some other embodiments of the invention, the forming of the 3D capacitor comprises forming a metal-insulator-metal stack in the pores of a porous anodic oxide region in the substrate.

### Brief Description of the Drawings

Further features and advantages of the present invention will become apparent from the following description of certain embodiments thereof, given by way of illustration only, not limitation, with reference to the accompanying drawings in which:
FIG. 1 illustrates a known monolithic RC component, in which:
   Fig.1A represents a cross-section through the component,
   Fig.1B represents an equivalent circuit to the Fig.2A structure, and
   Fig.1C illustrates an arrangement for connecting the RC component to another device, on a mounting substrate;
FIG. 2 illustrates a monolithic RC component according to a first embodiment of the present invention, in which:
   Fig.2A represents a cross-section through the component,
   Fig.2B represents an equivalent circuit to the Fig.3A structure, and
   Fig.2C illustrates an arrangement for connecting the RC component to another device, on a mounting substrate;
Fig.3 is a flow diagram illustrating steps in an embodiment of a method of fabricating the RC component of Fig.2;
Fig.4 is top view of an RC component fabricated according to the method of Fig.3; and
FIG.5 illustrates a cross-section through an RC component according to a second embodiment of the present invention.

### Detailed Description of Example Embodiments

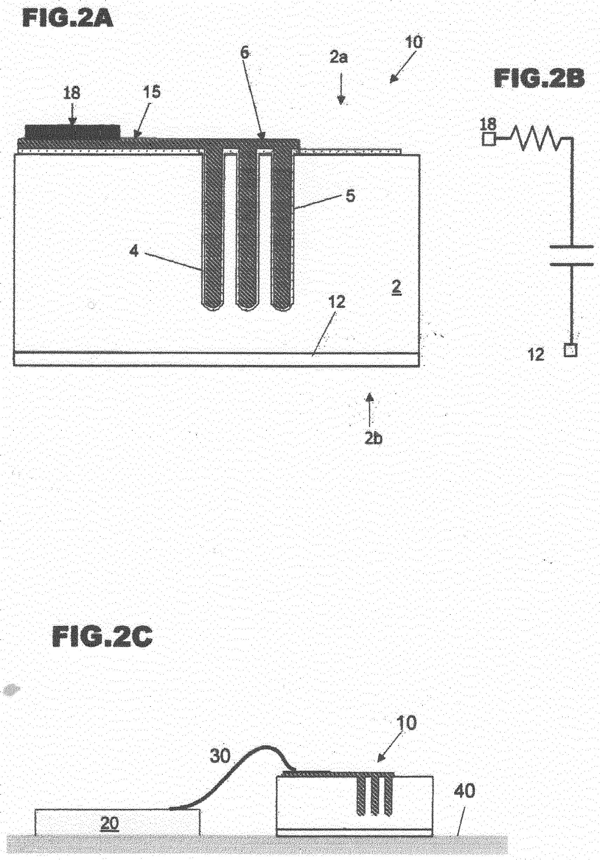

An RC component according to a first embodiment of the invention, and an example method for fabricating the component, will now be described with reference to Figs.2-4.

In the example illustrated by Figs.2-4, the 3D capacitor is made by a process which creates texture in a surface of a doped silicon substrate and then deposits the dielectric layer and top electrode layer conformally over the textured surface.

As can be seen from Fig.2A, the monolithic RC component 10 comprises a doped semiconductor substrate 2. The doped substrate 2 defines the bottom electrode of a MIS (metal-insulator-silicon) structure constituting a three-dimensional (3D) capacitor. The 3D capacitor structure is formed over a set of holes which extend from the surface at a first side 2a of the substrate 2 into the doped region 3. It will be understood that, in other embodiments, the 3D capacitor structure may make use of other texture, besides holes, provided in this surface of the substrate 2 (e.g. trenches, columns, ...).

A continuous dielectric layer 4 is formed on the set of holes and conformally follows the contours of the surface, lining the walls of the holes. The dielectric layer 4 constitutes the dielectric of the 3D capacitor. The top electrode of the 3D capacitor is formed by a conductive layer 5 which fills the holes and has a linear or planar portion 6 at the surface of the substrate. In this embodiment, the layer 15 is made of polysilicon. However, the resistor may be formed of other materials, e.g. TiN, or of a lamination of different materials, e.g. polysilicon and TiN layers laminated together.

The bottom terminal of the RC component 10 is provided at the bottom surface of the substrate 2. If desired, a conductive layer 12 may be provided on the bottom surface of the substrate 2 to improve conductivity and facilitate soldering of the RC component onto a mounting board.

The RC component 10 according to the embodiment of the invention includes a polysilicon resistor 15 connected in series with the 3D capacitor formed by the substrate 2 and layers 4 and 5. In this embodiment the polysilicon resistor 15 is a polysilicon layer that extends along the surface of the substrate on the side 2a where the top electrode portion 6 of the 3D capacitor is located. Indeed, in this embodiment a common polysilicon layer is used to constitute the top electrode portion 6 of the 3D capacitor and to constitute the polysilicon resistor 15. A contact 18 is electrically connected to the resistor 15 and constitutes a terminal of the RC component 10. If desired, an additional contact pad may be provided on the top portion 6 of the capacitor electrode, for example to enable current sensing, to permit a shunt across the resistance of the RC component 10, or to enable tests to be performed during the manufacturing process.

In the RC component 10 according to the embodiment of the invention represented in Figs.2A and 2B, the 3D capacitor structure extends through the substrate in the direction of the substrate's thickness, and opposing electrodes of the 3D capacitor are accessible at opposite sides 2a, 2b of the substrate 2. A polysilicon resistor 15 is connected in series to one of the capacitor electrodes and electrically connects that capacitor electrode to a connection terminal of the RC component. The other connection terminal of the RC component is located on the other side of the substrate.

The RC component 10 may be assembled and connected to a device 20, on a mounting substrate such as a DBC substrate 40, as illustrated in Fig.2C. A bonding wire 30 may connect the terminal 18 of the RC component 10 to a top contact (not shown) on the device 20.

The above-described RC component 10 has a well-controlled resistance value (<10% variation from the target value) and there is little variation in the resistance value as the temperature changes (of the order of a few 100s of ppm/K).

The semiconductor substrate 2 may be a silicon substrate, notably a silicon substrate that is doped to be highly conductive (e.g. to have resistivity from 1 mOhm.cm to 3 mOhm.cm).

Embodiments of the invention make use of a polysilicon resistor to enable the resistance value of the RC component to be set with precision and to enable the temperature drift of the resistance value to be reduced. The semiconductor substrate 2 may make a contribution to the overall resistance of the RC component and this may reduce the extent to which the overall resistance value is settable by patterning of the polysilicon resistor and/or may deteriorate the temperature performance. Accordingly, to reduce the contribution which the substrate makes to the overall resistance, the substrate may be highly doped so as to be low ohmic.

Conventional materials, processes and doping levels may be used to form the elements of the MIS capacitor structure. Thus, for example:
- the silicon substrate 2 may have a doping level in the range 10¹⁹ to 10²¹ atoms/cm³,
- the dielectric layer 4 may be made of a material (or stack of materials) such as SiN, Al₂O₃, SiO₂,
- and the conductive layer 5 is made of polysilicon.

In an advantageous implementation of this embodiment, a common layer of polysilicon forms the capacitor electrode 5, 6 at the side 2a of the RC component 10 and the resistor 15. The dimensions of the resistor 15 can be defined with high precision using known masking techniques, enabling the resistance value of the RC component to be set with precision.

The layer 12 may be made of any suitable conductive material: a non-limiting example is gold alloy. The terminal 18 may be made of various conductive materials: non-limiting examples include aluminium, copper, gold, and alloys thereof. In embodiments of the invention where the terminal 18 is made of high-purity aluminium the precision of the resistance value provided by the RC component 10 is enhanced. In such embodiments of the invention the purity of the aluminium is preferably greater than 98%, and more preferably greater than 99%.

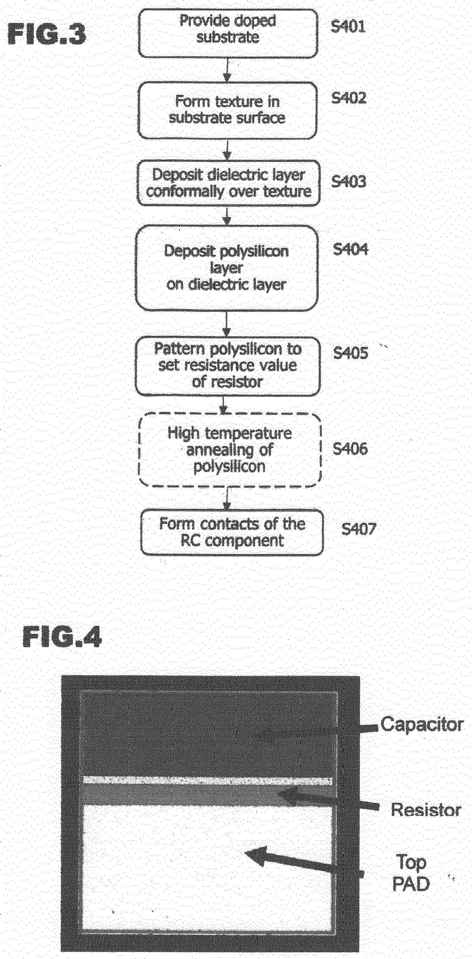

An example implementation of a method for fabricating an RC component 10 such as that of Fig.2A will now be described with reference to the flow chart of Fig.3.

First, a suitably-prepared doped semiconductor substrate is provided (S401) at the start of the method illustrated by Fig.3. This may be, for example, a low-ohmic silicon wafer in which multiple RC components according to the invention will be fabricated simultaneously (although, for simplicity, the following description only discusses formation of a single RC component). Next, texture is created in a surface of the substrate 2 (step S402). The texture may be created, for example, using masking and etching processes. Then the dielectric layer 4 is deposited so as to conformally coat the textured surface (step S403), for example by atomic level deposition (ALD), chemical vapour deposition, physical vapour deposition, etc...

Next, the conductive layer 5 is deposited over the dielectric layer 4 (step S404), for example by chemical vapour deposition, physical vapour deposition, ALD (Atomic layer deposition), etc. The conductive layer 5 may be deposited to conformally cover the dielectric layer and to extend above the surface of the substrate. For example, the conductive layer 5 may fill holes in the substrate and create a film on the surface of the substrate. In this example, a common polysilicon layer is deposited to form the capacitor electrode and the polysilicon resistor 15. A patterning process may then be used (step S405) to shape the top portion 6 of the capacitor electrode and to set the dimensions of the resistor 15. For example, a photolithographic process may be used to implement this patterning. By adjusting the dimensions of the resistor 15 the resistance value of the RC component 10 can be tuned to a target value.

In certain embodiments of the method a high-temperature annealing process (S406) is applied to the polysilicon. In embodiments of the invention where the high-temperature annealing process has been applied to the polysilicon, the precision of the resistance value provided by the RC component is enhanced. This effect was observed in experiments described below.

Experiment 1: 13 wafers were annealed at 900°C in a common enclosure: dispersion in the resistance of the finished products was 20.55%.

Experiment 2: 13 wafers were annealed at 900°C in a common enclosure, then annealed again in the common enclosure at 950°C: dispersion in the resistance of the finished products was 5.8%.

Experiment 3: 25 wafers were annealed at 900°C in a common enclosure: dispersion in the resistance of the finished products was 25.34%.

Experiment 4: 25 wafers were annealed at 900°C in a common enclosure, then annealed again in the common enclosure at 950°C: dispersion in the resistance of the finished products was 8.15%.

Experiment 5: 13 wafers were annealed at 1000°C in a common enclosure: dispersion in the resistance of the finished products was 1%.

Comparing the results of experiments 1 and 5, it can be seen that increasing the temperature of the annealing process above 900°C, notably to 1000°C, greatly reduces (indeed, it practically removes) dispersion in the resistance values observed in the finished products.

Comparing the results of experiments 1 and 3, and of experiments 2 and 4, it can be seen that reducing the number of wafers that are annealed at the same time in the enclosure reduces the dispersion in the resistance values observed in the finished products.

The terminal contacts (12, 18) of the RC component are formed by any convenient process (S407). For example, layer 12 may be formed by sputtering, electroplating or electroless deposition, and terminal 18 may be formed by the same kinds of processes. If it is desired to form an intermediate contact pad, i.e. on portion 6 of the capacitor electrode, then this contact pad may be formed by the same material and in a common process with the terminal 18.

Fig.4 is a top view of an RC component fabricated by the method according to Fig.3.

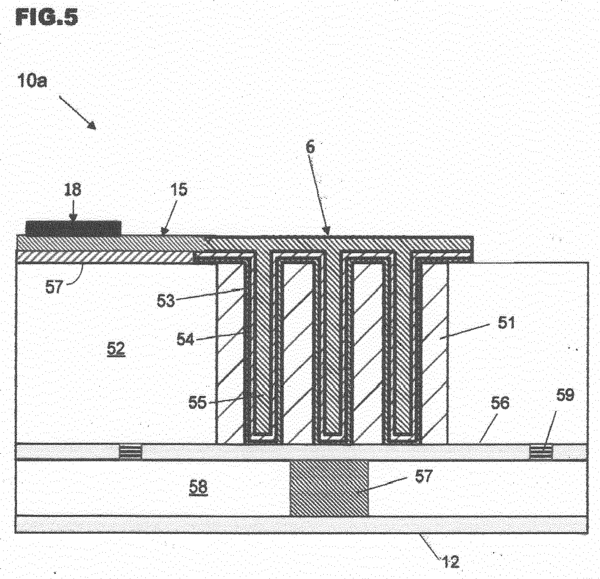

An RC component 10a according to a second embodiment of the invention, will now be described with reference to Fig.5. Elements similar to those in the first embodiment are designated by the same reference numerals and the description thereof is omitted.

In the example illustrated by Figs.5, the 3D capacitor is made by depositing layers of a MIM (metal-insulator-metal) stack in the pores of a porous anodic oxide region 51 provided in a metal layer 52. The lower metal layer of the MIM stack is designated 53 in Fig.5, the insulator layer is designated 54 and the top metal layer is designated 55.

As an example, the metal layer 52 may be an aluminium layer and the anodic oxide may be aluminium oxide made by anodization of a selected region in the aluminium layer. The pores of the anodic oxide region 51 may extend all the way through the metal layer 52 so that the inside of each pore communicates with an underlying conductive layer 56. In certain implementations of the second embodiment, the conductive layer 56 and the metal layer 52 are formed on a substrate 58, before the anodization process is performed. To enable the bottom terminal of the RC component 10a to be provided at the bottom of the structure, a conductive layer 12, serving as the bottom contact, may be provided and electrical contact between the bottom electrode of the 3D capacitor is achieved via a conductor 57 passing through the substrate 58. If desired, lateral isolation bands 59, made of electrically-insulating material, may be provided through the conductive layer 56, and this facilitates the integration of additional components in the device, either to the left and/or right sides of the 3D capacitor illustrated in Fig.5, or in additional layers above or below the illustrated structure.

Further information regarding how to fabricate a 3D capacitor in the pores of a porous anodic oxide region, and regarding techniques for integration of additional components, may be found in EP 3 063 789.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

For instance, it is to be understood that RC components according to the embodiments of the invention may be fabricated as monolithic devices (i.e. as stand-alone RC components), or may be integrated with additional components.

## Claims

1. An RC component (10) comprising:
a substrate (2) provided with a 3D capacitor (3-6) and with a resistor (15) connected in series with the 3D capacitor;
wherein the connection terminals (18,12) of the RC component are provided on respective first (2a) and second sides (2b) of the substrate (2), the first and second sides (2a,2b) facing each other in the thickness direction of the substrate; and
wherein the resistor (15) is a conductor extending along the surface of the substrate on the first side (2a) of the substrate.

2. The RC component (10) according to claim 1 wherein the resistor (15) is a conductor comprising polysilicon.

3. The RC component (10) according to claim 1 or 2, wherein a common polysilicon layer constitutes the resistor (15) and a first electrode (5,6) of the 3D capacitor.

4. The RC component according to any one of claims 1 to 3, wherein the connection terminal (18) on the first side (2a) of the substrate is made of aluminium or of an aluminium alloy containing at least 98% aluminium.

5. The RC component (10) according to any one of claims 1 to 4, wherein the substrate is a doped semiconductor substrate (2) forming one electrode of the 3D capacitor.

6. The RC component (10a) according to any one of claims 1 to 4, wherein the 3D capacitor comprises a metal-insulator-metal stack (53-55) formed in the pores of a porous anodic oxide layer (51) provided in the substrate.

7. The RC component according to any previous claim, wherein the component is configured as an RC snubber.

8. A method of fabricating an RC component (10), comprising:
forming a 3D capacitor (4,6) in a substrate (2);
forming a resistor (15) along the surface of the substrate on a first side (2a) of the substrate, the resistor (15) being connected in series with the 3D capacitor; and
forming connection terminals (18,12) of the RC component on the first side (2a) and on a second (2b) side of the substrate, the first and second sides (2a,2b) facing each other in the thickness direction of the substrate

9. The fabrication method according to claim 8, wherein the forming of the resistor comprises forming, along the surface of the substrate on the first side (2a) of the substrate, a polysilicon conductor (15) extending from a first electrode (5,6) of the 3D capacitor to the connection terminal (18) on the first side of the substrate.

10. The fabrication method according to claim 8 or 9, wherein the forming of the resistor (15) comprises depositing a polysilicon layer and adjusting the dimensions of the polysilicon layer to set the resistance value of the resistor.

11. The fabrication method according to any one of claims 8 to 10, wherein the forming of the 3D capacitor comprises:
texturing the surface of a doped semiconductor substrate (2);
forming a continuous dielectric layer (4) conformally over the texture in the doped semiconductor substrate (2),
forming, on the dielectric layer (4), a polysilicon layer constituting an electrode (5,6) of the 3D capacitor and constituting said resistor (15).

12. The fabrication method according to any one of claims 9 to 11, and comprising a high temperature annealing of the polysilicon material.

13. The fabrication method according to any one of claims 8 to 10, wherein the forming of the 3D capacitor comprises forming a metal-insulator-metal stack (53-55) in the pores of a porous anodic oxide region (51) in the substrate.

14. The fabrication method according to any one of claims 8 to 13, wherein the forming of the connection terminals comprises forming the connection terminal (18), on the first side (2a) of the substrate, of aluminium or of an aluminium alloy containing at least 98% aluminium.

15. The fabrication method according to any one of claims 8 to 14, configured to fabricate an RC snubber.
